(19) Europäisches Patentamt
European Patent Office
Office européen des brevets

(11) **EP 3 447 876 A1**

(12) **EUROPÄISCHE PATENTANMELDUNG**

(43) Veröffentlichungstag:
**27.02.2019 Patentblatt 2019/09**

(51) Int Cl.:
*H02J 7/00* (2006.01)   *G01R 31/36* (2019.01)

(21) Anmeldenummer: **17187423.3**

(22) Anmeldetag: **23.08.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Hilti Aktiengesellschaft**
**9494 Schaan (LI)**

(72) Erfinder:
• **HAUSER, Klaus**
**86830 Schwabmünchen (DE)**
• **KOSCHECK, David**
**81735 München (DE)**
• **MAYER, Stefan**
**85221 Dachau (DE)**

(74) Vertreter: **Hilti Aktiengesellschaft**
**Corporate Intellectual Property**
**Feldkircherstrasse 100**
**Postfach 333**
**9494 Schaan (LI)**

(54) **ERMITTELN DER LADUNG EINES AKKUMULATORS BEI EINEM LADEVORGANG**

(57) Verfahren zum Ermitteln eines Ladungswertes für ein System enthaltend eine Ladevorrichtung sowie wenigstens einen Akkumulator, wobei der wenigstens eine Akkumulator zur Aufnahme und Speicherung einer elektrischen Energie mit der Ladevorrichtung verbindbar ist,

Das Verfahren enthält die Verfahrensschritte

- Erfassen eines ersten Ladungswertes einer elektrischen Ladung des wenigstens einen Akkumulators zu einem ersten Zeitpunkt;

- Erfassen eines Stromwertes eines elektrischen Stroms, welcher zum Laden des wenigstens einen Akkumulators von der Ladevorrichtung zu dem wenigstens einen Akkumulator fließt, zwischen einem ersten und zweiten Zeitpunkt;

- Ermitteln eines zweiten Ladungswertes anhand des erfassten Stromwertes zwischen dem ersten und zweiten Zeitpunkt; und

- Addieren des zweiten Ladungswerts von dem ersten Ladungswert zum Ermitteln eines dritten Ladungswertes in dem Akkumulator zu dem zweiten Zeitpunkt.

Akkumulator, Ladevorrichtung sowie System enthaltend wenigstens einen Akkumulator sowie eine Ladevorrichtung zur Durchführung des Verfahrens.

Fig. 1

**Beschreibung**

Die vorliegende Erfindung betrifft ein Verfahren zum Ermitteln eines Ladungswertes für ein System enthaltend eine Ladevorrichtung sowie wenigstens einen Akkumulator, wobei der wenigstens eine Akkumulator zur Aufnahme und Speicherung einer elektrischen Energie mit der Ladevorrichtung verbindbar ist.

Des Weiteren betrifft die vorliegende Erfindung einen Akkumulator sowie eine Ladevorrichtung zur Durchführung des Verfahrens. Darüber hinaus betrifft die vorliegende Erfindung ein System enthaltend wenigstens einen Akkumulator sowie eine Ladevorrichtung zur Durchführung des Verfahrens.

Kabellose Werkzeugmaschine können zur Stromversorgung mit einem Akkumulator, auch Akku genannt, betrieben werden. Bei der kabellosen Werkzeugmaschine kann es sich beispielsweise um einen Akku-Schrauber, einen Bohrhammer oder dergleichen handeln.

Akkumulatoren enthalten für gewöhnlich eine Anzahl an Speicherzellen bzw. Energiespeicherzellen für elektrische Energie bzw. eine elektrische Ladung. Zur Kontrolle eines Lade- bzw. Entladevorgangs der Speicherzellen, bei dem die Speicherzellen entweder mit einer elektrischen Energie geladen oder die elektrische Energie aus den Speicherzellen genommen wird, verfügt ein moderner Akkumulator über eine Steuerung bzw. Steuerungselektronik. Die Speicherzellen werden auch als Akkuzellen bezeichnet.

Akkumulatoren gemäß dem Stand der Technik verfügen häufig aus Kostengründen nicht über eine Vorrichtung, um verlässlich und präzise den aktuellen Ladungszustand bzw. den Stand der gespeicherten Energiemenge des Akkumulators zu jedem Zeitpunkt anzuzeigen.

Eine möglichst genaue Erfassung des aktuellen Ladungszustands bzw. der schon gespeicherten Energiemenge in dem Akkumulator ermöglicht es jedoch einen Ladevorgang besser zu überwachen und insbesondere den Zeitpunkt, an dem der Akkumulator einen bestimmten Ladezustand (auch State of Charge genannt) erreicht hat, einzuschätzen.

Darüber hinaus dient eine möglichst genaue Erfassung des aktuellen Ladungszustands bzw. der schon gespeicherten Energiemenge in dem Akkumulator um besser abzuschätzen, wie lange das Laden des Akkumulators mit elektrischer Energie bis zu einem bestimmten Ladezustand durch die Ladevorrichtung noch dauert.

Gemäß dem Stand der Technik ist es bereits möglich mit Hilfe der Messung der Leerlaufspannung des Akkumulators den aktuellen bzw. tatsächlichen Ladezustand (d.h. die bereits im Akkumulator gespeicherte Ladungsmenge bzw. Energiemenge) ermitteln zu können. Diese Messung ist jedoch nur in einem Zustand möglich, wenn kein elektrischer Strom von der Ladevorrichtung zu dem Akkumulator fließt. Eine automatische Unterbrechung des Ladevorgangs ist dabei möglich, wenn beispielsweise der Akkumulator und/oder die Ladevorrichtung bei dem Ladevorgang zu heiß geworden sind. Ein Ladevorgang kann in einem derartigen Fall erst sicher fortgesetzt werden, wenn der Akkumulator bzw. die Ladevorrichtung wieder ausreichend abgekühlt sind.

Aufgabe der vorliegenden Erfindung ist es daher, einen Verfahren zum Ermitteln eines Ladungswertes für ein System enthalten eine Ladevorrichtung sowie wenigstens einen Akkumulator, wobei der wenigstens eine Akkumulator zur Aufnahme und Speicherung einer elektrischen Energie mit der Ladevorrichtung verbindbar ist. Des Weiteren ist es auch Aufgabe der vorliegenden Erfindung einen Akkumulator, eine Werkzeugmaschine und ein System enthaltend wenigstens einen Akkumulator sowie eine Ladevorrichtung zur Durchführung des Verfahrens bereitzustellen, mit denen das vorstehend genannte Problem gelöst werden kann.

Die Aufgabe wird gelöst durch den Gegenstand des unabhängigen Anspruchs 1, 2, 3 und 4.

Die Aufgabe wird insbesondere gelöst durch ein Verfahren zum Ermitteln eines Ladungswertes für ein System enthalten eine Werkzeugmaschine sowie wenigstens einen Akkumulator, wobei der wenigstens eine Akkumulator zur Versorgung der Werkzeugmaschine mit elektrischer Energie dient.

Erfindungsgemäß sind für das Verfahren die folgenden Schritte vorgesehen

- Erfassen eines ersten Ladungswertes einer elektrischen Ladung des wenigstens einen Akkumulators zu einem ersten Zeitpunkt;

- Erfassen eines Stromwertes eines elektrischen Stroms, welcher zum Laden des wenigstens einen Akkumulators von der Ladevorrichtung zu dem wenigstens einen Akkumulator fließt, zwischen einem ersten und zweiten Zeitpunkt;

- Ermitteln eines zweiten Ladungswertes anhand des erfassten Stromwertes zwischen dem ersten und zweiten Zeitpunkt; und

- Addieren des zweiten Ladungswerts von dem ersten Ladungswert zum Ermitteln eines dritten Ladungswertes in dem Akkumulator zu dem zweiten Zeitpunkt.

Hierdurch bzw. insbesondere durch die Ermittlung des dritten Ladungswertes kann der aktuelle bzw. tatsächliche Ladezustand des Akkumulators auch während des Ladevorgang des Akkumulators, d.h. wenn elektrischer Strom von der Ladevorrichtung zu dem Akkumulator fließt, zuverlässig ermittelt werden. Somit ist man jederzeit während des Ladevorgangs in der Lage, die im Akkumulator schon gespeicherte Energie bzw. elektrische Ladung für bevorstehende Arbeiten genau einzuschätzen bzw. die Zeit bis zum Erreichen eines bestimmten Ladezustands abzuschätzen.

Es ist dabei gemäß einer vorteilhaften Ausführungsform möglich, dass der erste Ladungswert einer elektrischen Ladung des wenigstens einen Akkumulators auf einem nichtflüchtigen Speicher (Non-Volatile Memory (NVM)) gespeichert wird.

Der Zeitraum zwischen dem ersten und zweiten Zeitpunkt kann auch als erstes Zeitintervall bezeichnet werden. Der Zeitraum zwischen dem zweiten und dritten Zeitpunkt kann auch als zweites Zeitintervall bezeichnet werden.

Des Weiteren wird die Aufgabe gelöst durch einen Akkumulator mit einer Ladevorrichtung verbindbar, welcher zur Durchführung des Verfahrens ausgestaltet ist. Der Akkumulator kann dabei eine Ladungsmessvorrichtung enthalten zum Erfassen eines ersten Ladungswertes einer elektrischen Ladung in dem Akkumulator.

Darüber hinaus wird die Aufgabe gelöst durch eine Ladevorrichtung mit einem Akkumulator verbindbar zur Durchführung des Verfahrens. Die Ladevorrichtung kann dabei eine Strommessvorrichtung enthalten zum Erfassen eines Stromwertes eines elektrischen Stroms in der Ladevorrichtung, welcher von der Ladevorrichtung zu dem wenigstens einen Akkumulator zum Aufladen des Akkumulators fließt. Ferner kann die Ladevorrichtung einen Prozessor enthalten zum Ermitteln eines zweiten Ladungswertes anhand des erfassten Stromwertes zwischen einem ersten und zweiten Zeitpunkt.

Des Weiteren wird die Aufgabe gelöst durch ein System enthaltend wenigstens einen Akkumulator sowie eine Ladevorrichtung zur Durchführung des Verfahrens.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:

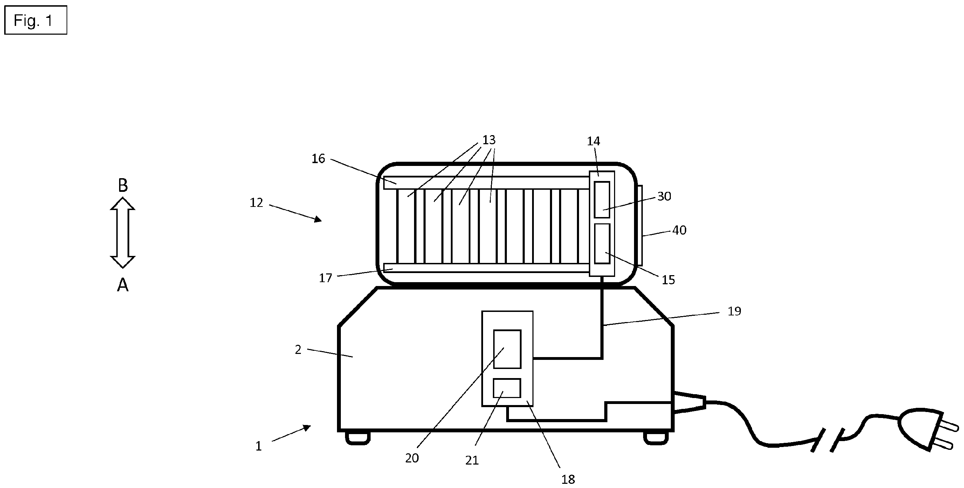

Fig. 1    eine Schnittansicht einer erfindungsgemäßen Ladevorrichtung mit einem erfindungsgemäßen an der Ladevorrichtung angeschlossenen Akkumulator.

**Ausführungsbeispiele:**

In Figuren 1 ist eine erfindungsgemäße Ladevorrichtung 1 zusammen mit einem erfindungsgemäßen Akkumulator 12 dargestellt. Der Akkumulator 12 ist für einen Ladevorgang, durch den der Akkumulator 12 mit einer elektrischen Energie geladen wird, lösbar mit der Ladevorrichtung 1 verbunden.

Die Ladevorrichtung 1 ist beispielsweise in Form eines Ladegeräts ausgestaltet und enthält im Wesentlichen ein Gehäuse 2 sowie ein Netzstromanschlusskabel. Das Netzstromanschlusskabel dient zum Anschließen der Ladevorrichtung 1 mit einer Netzstromquelle (auch Steckdose genannt), um elektrischen Strom von der Netzstromquelle zu der Ladevorrichtung 1 fließen zu lassen. Die Netzstromquelle ist in der Figur nicht gezeigt.

Der Akkumulator 12 kann in einer Ausgestaltungsform zur Versorgen einer Werkzeugmaschine 1 mit elektrischer Energie bzw. mit elektrischem Strom dienen. Der Akkumulator 12 wird hierzu von der Ladevorrichtung 1 getrennt mit einer Werkzeugmaschine verbunden. Bei der Werkzeugmaschine kann es sich beispielsweise um einen Akku-Schrauber, eine Bohrmaschine, eine Säge oder dergleichen handeln. Die Werkzeugmaschine ist in der Figur nicht dargestellt.

Der Akkumulator 12 enthält hierzu im Wesentlichen in seinem Inneren eine Anzahl an Energiespeicherzellen 13 (auch Akku-Zellen genannt) sowie eine Steuerung 14. Die Energiespeicherzellen 13 und die Steuerung 14 sind miteinander verbunden. Mit Hilfe der Energiespeicherzellen 13 kann elektrische Energie bzw. eine elektrische Ladung gespeichert werden.

Die Steuerung 14 des Akkus 12 enthält wiederum eine Ladungsmessvorrichtung 15. Die Ladungsmessvorrichtung 15 dient zum Erfassen eines ersten Ladungswertes einer elektrischen Ladung, die in den Energiespeicherzellen 13 gespeichert ist. Der erste Ladungswert entspricht dabei der zur Verfügung stehenden elektrischen Ladung in den Energiespeicherzellen 13 zu einem bestimmten Zeitpunkt.

Die einzelnen Energiespeicherzellen 13 sind über eine obere und untere Zellenhalterung 16, 17 mechanisch und elektrisch mit der Steuerung 14 verbunden, sodass elektrische Energie bzw. elektrischer Strom von den einzelnen Energiespeicherzellen 13 zu der Steuerung 14 fließen kann. Die in der Steuerung 14 enthaltende Ladungsmessvorrichtung 15 misst in Zeitintervallen, d.h. zu bestimmten Zeitpunkten, die in den Energiespeicherzellen 13 gespeicherte elektrische Ladung. Die Werte der gemessenen elektrischen Ladung werden in einem nichtflüchtigen Speicher 30 gespeichert.

Im Inneren des Gehäuses 2 der Ladevorrichtung 1 ist eine Steuerungsvorrichtung 18 positioniert. Die Steuerungsvorrichtung 18 ist über eine entsprechende Leitungen 19 mit der Steuerung 14 des Akkumulators 12 verbunden. Die Leitungen 19 dienen dabei zum Übertragen von Signalen, d.h. als Kommunikationsleitung, und zum Übertragen von elektrischem Strom. Die Steuerungsvorrichtung 18 enthält des Weiteren eine Strommessvorrichtung 20 sowie einen Prozessor 21.

Die Strommessvorrichtung 20 dient zum Erfassen eines Stromwertes eines elektrischen Stroms, welcher von der Ladevorrichtung 1 zu den einzelnen Energiespeicherzellen 13 des Akkumulators 12 fließt. Der elektrische Strom fließt von der Ladevorrichtung 1 zu den Energiespeicherzellen 13, um den Akkumulator 12 zu laden. Zum Laden des Akkumulators 12 wird elektrische Energie bzw. eine elektrische Ladung in den Energiespeicherzellen 13 gespeichert. Das Erfassen bzw. Messen des Stromwertes erfolgt dabei zwischen einem ers-

ten Zeitpunkt $t_1$ und zweiten Zeitpunkt $t_2$ für eine bestimmte Zeitdauer bzw. für ein bestimmtes Zeitintervall.

Zur Durchführung des erfindungsgemäßen Verfahrens wird der Akkumulator 12 in Pfeilrichtung A auf die Ladevorrichtung 1 positioniert. Der Akkumulator 12 und die Ladevorrichtung 1 weisen hierzu jeweils eine zueinander korrespondierende Schnittstelle auf, sodass der Akkumulator 12 und die Ladevorrichtung 1 mechanisch, elektrisch und elektronisch miteinander in Verbindung stehen. Die jeweilige Schnittstelle des Akkumulators 12 und der Ladevorrichtung 1 sind in der Figur nicht dargestellt. Um den Akkumulator 12 und die Ladevorrichtung 1 wieder voneinander zu trennen wird der Akkumulator 12 in Pfeilrichtung B bewegt.

zunächst die aktuelle elektrische Ladung $Q(t_1)$ in den Energiespeicherzellen 13 zu einem bestimmten ersten Zeitpunkt $t_1$ erfasst. Die Erfassung bzw. die Messung der Ladung $Q(t_1)$ erfolgt dabei mittels der Ladungsmessvorrichtung 15 in dem Akkumulator 12. Der Wert der aktuellen elektrischen Ladung $Q(t_1)$ wird in dem Speicher 30 gespeichert. Es können dabei auch mehrere Werte der elektrischen Ladung systematisch in dem Speicher 30 gespeichert werden. Der Wert der aktuellen elektrischen Ladung $Q(t_1)$ wird über die Leitung 19 von der Steuerung 14 des Akkumulators 12 zu der Steuerungsvorrichtung 18 der Werkzeugmaschine 1 gesendet.

Wenn der Akkumulator 12 für einen Ladevorgang mit der Ladevorrichtung 1 verbunden ist, fließt eine elektrische Ladung bzw. ein elektrischer Strom von der Ladevorrichtung 1 über die Steuerungsvorrichtung 18, die Leitung 19, die Steuerung 14 und zu den Energiespeicherzellen 13 des Akkumulators 12.

Die Strommessvorrichtung 20 der Steuerungsvorrichtung 18 erfasst die Menge des elektrischen Stroms, der in einem ersten Zeitintervall, d.h. zwischen einem ersten Zeitpunkt $t_1$ und zweiten Zeitpunkt $t_2$ von der Ladevorrichtung 1 zu den Energiespeicherzellen 13 fließt.

Mit Hilfe der Gleichungen:

$$Q = I \times t$$

$$Q(t_3) = Q(t_1) + \int_{t_1}^{t_2} I(t)\, dt$$

wobei

$Q(t_3)$ = gesamte elektrische Ladung in den Energiespeicherzellen 13 zum dritten Zeitpunkt $t_3$;
$Q(t_1)$ = aktuelle elektrische Ladung in den Energiespeicherzellen 13 zum ersten Zeitpunkt;
$I$ = Stromstärke in Amper (A bzw. mA)
$t$ = Zeit
$t_1$ bis $t_2$ = Zeitintervall zwischen einem ersten und zweiten Zeitpunkt

ist, wird durch den Prozessor 21 die elektrische Ladung als Integral des elektrischen Stroms, der für den Ladevorgang von der Ladevorrichtung 1 zu dem Akkumulator 12 fließt, über den Zeitintervall, d.h. zwischen dem ersten Zeitpunkt $t_1$ und den zweiten Zeitpunkt $t_2$, ermittelt.

Zum Ermitteln der elektrischen Ladung dient die Gegebenheit, dass die elektrische Ladung, die in oder durch einen Körper geflossen ist, das Integral des elektrischen Stromes über der Zeit darstellt.

Der Wert der in der Ladevorrichtung 1 ermittelten elektrischen Ladung (d.h. das Integral des geflossenen elektrischen Stromes über der Zeit) wird über die Leitungen 19 von der Steuerungsvorrichtung 18 zu der Steuerung 14 des Akkumulators 12 gesendet. In der Steuerung 14 des Akkumulators 12 wird der Wert der ermitteln elektrischen Ladung zu der erfassten elektrischen Ladung $Q(t_1)$ hinzugezählt (addiert), wodurch die eigentlich in den Energiespeicherzellen 13 schon gespeicherte elektrische Ladung $Q(t_3)$ zum dritten Zeitpunkt $t_3$ ermittelt ist. Mit anderen Worten: die in dem Akkumulator 12 ermittelte elektrische Ladung $Q(t_1)$ und die durch die Ladevorrichtung 1 errechnete Ladung ergeben zusammen die gesamte Ladung $Q(t_3)$.

An einer Anzeigevorrichtung 40 an dem Akkumulator 12 kann die ermittelte aktuell schon verfügbare elektrische Ladung $Q(t_3)$ zum Zeitpunkt $t_3$ angezeigt werden. Der Anwender der Werkzeugmaschine wird somit informiert, wieviel elektrische Energie tatsächlich schon mit dem Akkumulator 12 zur Verfügung steht.

Es ist gemäß einer weiteren (nicht in den Figuren gezeigten) Ausführungsform auch möglich, dass die Anzeigevorrichtung 40 zur Anzeige der ermittelten aktuell schon in dem Akkumulator 12 verfügbaren elektrischen Ladung $Q(t_3)$ zum Zeitpunkt $t_3$ an der Ladevorrichtung 1 positioniert ist.

Darüber hinaus ist es gemäß einer weiteren (nicht in den Figuren gezeigten) Ausführungsform auch möglich, dass die Anzeige der ermittelten aktuell schon in den Energiespeicherzellen 13 verfügbaren elektrischen Ladung $Q(t_3)$ zum Zeitpunkt $t_3$ mittels einer drahtlosen Verbindung zu einem externen Anzeigegerät gesendet wird. Bei dem externen Anzeigegerät kann es sich beispielsweise um eine Brille für Augmented Reality, ein Smartphone oder dergleichen handeln.

**Patentansprüche**

1. Verfahren zum Ermitteln eines Ladungswertes für ein System enthaltend eine Ladevorrichtung (1) sowie wenigstens einen Akkumulator (12), wobei der wenigstens eine Akkumulator (12) zur Aufnahme und Speicherung einer elektrischen Energie mit der Ladevorrichtung (1) verbindbar ist,
**gekennzeichnet durch** die folgenden Verfahrensschritte

   - Erfassen eines ersten Ladungswertes einer elektrischen Ladung des wenigstens einen Akkumulators (12) zu einem ersten Zeitpunkt ($t_1$);

- Erfassen eines Stromwertes eines elektrischen Stroms, welcher zum Laden des wenigstens einen Akkumulators (12) von der Ladevorrichtung (1) zu dem wenigstens einen Akkumulator (12) fließt, zwischen einem ersten und zweiten Zeitpunkt ($t_1$, $t_2$);

- Ermitteln eines zweiten Ladungswertes anhand des erfassten Stromwertes zwischen dem ersten und zweiten Zeitpunkt ($t_1$, $t_2$); und

- Addieren des zweiten Ladungswerts von dem ersten Ladungswert zum Ermitteln eines dritten Ladungswertes in dem Akkumulator (12) zu dem zweiten Zeitpunkt ($t_2$).

2. Akkumulator (12) mit einer Ladevorrichtung (1) verbindbar zur Durchführung des Verfahrens nach Anspruch 1,
**gekennzeichnet durch** eine Ladungsmessvorrichtung (15) zum Erfassen eines ersten Ladungswertes einer elektrischen Ladung in dem Akkumulator (12).

3. Ladevorrichtung (1) mit einem Akkumulator (12) verbindbar zur Durchführung des Verfahrens nach Anspruch 1,
**gekennzeichnet durch** eine Strommessvorrichtung (20) zum Erfassen eines Stromwertes eines elektrischen Stroms in der Ladevorrichtung (1), welcher zum Laden des wenigstens einen Akkumulators (12) von der Ladevorrichtung (1) zu dem wenigstens einen Akkumulator (12) fließt, sowie einen Prozessor (21) zum Ermitteln eines zweiten Ladungswertes anhand des erfassten Stromwertes zwischen einem ersten und zweiten Zeitpunkt ($t_1$, $t_2$).

4. System enthaltend wenigstens einen Akkumulator (12) sowie eine Ladevorrichtung (1) zur Durchführung des Verfahrens nach Anspruch 1.

EP 3 447 876 A1

Fig. 1

Europäisches
Patentamt

European
Patent Office

Office européen
des brevets

## EUROPÄISCHER RECHERCHENBERICHT

Nummer der Anmeldung

EP 17 18 7423

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2017/160346 A1 (NODA MASAFUMI [JP] ET AL) 8. Juni 2017 (2017-06-08)<br>* Abbildungen 1,3,4 *<br>* Absatz [0047] *<br>* Absatz [0059] *<br>* Absatz [0065] *<br>* Absatz [0092] - Absatz [0093] *<br>* Absatz [0111] - Absatz [0112] *<br>----- | 1-4 | INV.<br>H02J7/00<br>G01R31/36 |

RECHERCHIERTE
SACHGEBIETE (IPC)

H02J
G01R

Der vorliegende Recherchenbericht wurde für alle Patentansprüche erstellt

| Recherchenort | Abschlußdatum der Recherche | Prüfer |
|---|---|---|
| München | 31. Oktober 2017 | Martin, Raynald |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes
Dokument

EPO FORM 1503 03.82 (P04C03)

**EP 3 447 876 A1**

**ANHANG ZUM EUROPÄISCHEN RECHERCHENBERICHT
ÜBER DIE EUROPÄISCHE PATENTANMELDUNG NR.**

EP 17 18 7423

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-10-2017

| Im Recherchenbericht angeführtes Patentdokument | Datum der Veröffentlichung | Mitglied(er) der Patentfamilie | Datum der Veröffentlichung |
|---|---|---|---|
| US 2017160346 A1 | 08-06-2017 | CN 103543406 A | 29-01-2014 |
| | | EP 2685270 A2 | 15-01-2014 |
| | | JP 6207127 B2 | 04-10-2017 |
| | | JP 2014020798 A | 03-02-2014 |
| | | US 2014019074 A1 | 16-01-2014 |
| | | US 2017160346 A1 | 08-06-2017 |

EPO FORM P0461

Für nähere Einzelheiten zu diesem Anhang : siehe Amtsblatt des Europäischen Patentamts, Nr.12/82